# EUROPEAN PATENT APPLICATION

(11) **EP 2 773 042 A1**
(43) Date of publication of application: **03.09.2014**
(21) Application number: 14154651.5
(22) Date of filing: 11.02.2014
(51) Int. Cl.: H03K 17/96

(54) **Input operation receiving apparatus and threshold value adjusting method**

(30) Priority: 28.02.2013 JP 2013039330; 28.02.2013 JP 2013039331
(71) Applicant: Honda Motor Co., Ltd., Tokyo 107-8556 (JP)
(72) Inventor: Shibata, Naoki, Saitama, 351-0193 (JP)
(74) Representative: Prechtel, Jörg

(57) **Abstract**

An input operation receiving apparatus (1) includes a mechanical switch (20); a capacitance sensor (30) that is provided at a position where an operator comes into contact therewith when the mechanical switch is operated and that detects capacitance; and an adjustment unit (48) that adjusts a threshold value for a contact determination when the capacitance sensor is used as a switch, on the basis of a detection value at a time of operation, the detection value at the time of operation being a detection value of the capacitance sensor when an operation of the mechanical switch is detected.

## Description

### BACKGROUND OF THE INVENTION

### Field of the Invention

The present invention relates to an input operation receiving apparatus and a threshold value adjusting method.

### Description of Related Art

In the related art, switches (hereinafter referred to as electrostatic switches) that detect a contact operation of an operator on the basis of a change in capacitance are used. In the electrostatic switches, for example, a threshold value is provided for capacitance detected by a capacitance sensor, and when the capacitance that increases as an operator's finger or the like approaches to the capacitance sensor exceeds the threshold value, it is determined that the contact operation has been made.

Incidentally, in the electrostatic switches, the detected capacitance fluctuates based on a wearing of gloves, individual differences, the state (from sweat or injury) of fingertips, and the like. Therefore, if the threshold value is set to a fixed value, there is a problem in that an accurate determination is difficult to perform.

Similarly, Japanese Unexamined Patent Application, First Publication No. 2006-347215 describes a touch switch in which a sub contact detecting sensor is provided as sub detecting means that detects operator's contact at a position different from a contact detecting sensor that detects contact during a switch operation. In this touch switch, the contact detecting sensor and the sub contact detecting sensor are attached to a steering wheel of a vehicle. The sub contact detecting sensor is attached to a grip portion of the steering wheel where it is likely that a driver (operator) comes into contact with the sub contact detecting sensor while driving. Both the contact detecting sensor and the sub contact detecting sensor are capacitance sensors. When the capacitance detected by the sub contact detecting sensor is small (a change in output voltage is small), the threshold value of the contact detecting sensor is adjusted to high sensitivity.

Additionally, in the related art, devices (switches) capable of receiving an operator's input operation are used in every aspect. As switches, for example, there are known mechanical switches in which a moving part moves as an operator performs a depression operation, and consequently, an electrode comes into contact with the moving part to output an ON signal, or switches (electrostatic switches) that detect an operator's contact operation on the basis of a change in capacitance. In the electrostatic switches, for example, a threshold value is provided for capacitance detected by a capacitance sensor, and when the capacitance that increases as an operator's finger or the like approaches to the capacitance sensor exceeds the threshold value, it is determined that the contact operation has been made.

In relation to the above description, Japanese Unexamined Patent Application, First Publication No. 2011-39966 describes a device that detects an operation to a movable grip. In this device, a touch sensor (electrostatic switch) that detects contact and a rotary encoder and a potentiometer that detect the amount of operation are attached to left and right grips, respectively. When there is no output of the touch sensor and there is the output of the rotary encoder or the potentiometer, it is determined that there is a failure in either the touch sensor or the rotary encoder.

### SUMMARY OF THE INVENTION

However, in the touch switch described in the above Japanese Unexamined Patent Application, First Publication No. 2006-347215, the operator does not necessarily come into contact with the sub contact detecting sensor. Additionally, even if it is assumed that the operator comes into contact with the sub contact detecting sensor, contact may not be precisely detected if the operator wears gloves or the like because the capacitance sensor is also used as the sub contact detecting sensor. As a result, the reliability of detection result itself of the sub contact detecting sensor may be low and the threshold value of the contact detecting sensor may not be appropriately adjusted. If an attempt to enhance the reliability of detection of the sub contact detecting sensor is made, for example, it is necessary to determine whether or not the contact with the sub contact detecting sensor has been made by multiple sampling, and rapid adjustment may become difficult.

Additionally, in the device described in the above Japanese Unexamined Patent Application, First Publication No. 2011-39966, there is no alternative means when it is determined that the touch switch, the rotary encoder, or the potentiometer has failed, and is was necessary to just wait for repairs, maintenance, or the like being performed.

An aspect of the invention has been made in consideration of the above situation, and an object of the invention is to rapidly and appropriately adjust the threshold value for contact determination when a capacitance sensor is used as a switch.

Additionally, another aspect of the invention has been made in consideration of the above situation, and an object of the invention to provide an input operation receiving apparatus that can perform smooth alternative processing when an abnormality occurs.

The following configurations are adopted in aspects related to the invention to solve the above described problems.
(1) An input operation receiving apparatus of an aspect of the invention includes a mechanical switch; a capacitance sensor that is provided at a position where an operator comes into contact therewith when the mechanical switch is operated and that detects capacitance; and an adjustment unit that adjusts a threshold value for a contact determination when the capacitance sensor is used as a switch, on the basis of a detection value at a time of operation, the detection value at the time of operation being a detection value of the capacitance sensor when an operation of the mechanical switch is detected.
(2) In the aspect of the above (1), the capacitance sensor may be provided so as to be superimposed on the mechanical switch.
(3) In the aspect of the above (1) or (2), the adjustment unit may adjust the threshold value with a tendency in which the threshold value increases as the detection value at the time of operation increases.
(4) In the aspect of the above (3), the adjustment unit may continuously change the threshold value with respect to a change of the detection value at the time of operation in both of a control region where the detection value at the time of operation is less than a predetermined value and a control region where the detection value at the time of operation is equal to or more than a predetermined value, and may discontinuously change the threshold value with respect to a change of the detection value at the time of operation at a boundary between a control region where the detection value at the time of operation is less than a predetermined value and a control region where the detection value at the time of operation is equal to or more than a predetermined value.
(5) In the aspect of the above (4), the threshold value when the detection value at the time of operation is equal to or more than a predetermined value may be discontinuously increased when compared to the threshold value when the detection value at the time of operation is less than a predetermined value, at a boundary between a control region where the detection value at the time of operation is less than a predetermined value and a control region where the detection value at the time of operation is equal to or more than a predetermined value.
(6) In the aspect of the above (1) to (5), the input operation receiving apparatus may further include another capacitance sensor that is different from the capacitance sensor that is formed so as to be superimposed on the mechanical switch and detects capacitance between the capacitance sensor and an approaching object. The adjustment unit may adjust a threshold value for contact determination when the capacitance sensor that is formed so as to be superimposed on the mechanical switch and detects the capacitance between the capacitance sensor and the approaching object is used as a switch, and/or a threshold value for contact determination when the another capacitance sensor is used as a switch.
(7) A threshold value adjusting method of an aspect related to the invention is a threshold value adjusting method that adjusts a threshold value for contact determination when a capacitance sensor is used as a switch, in an input operation receiving apparatus including a mechanical switch and the capacitance sensor that is formed so as to be superimposed on the mechanical switch and detects a capacitance between the capacitance sensor and an approaching object. The method includes acquiring a detection value of the capacitance sensor when an operation of the mechanical switch is detected; and adjusting a threshold value for contact determination when the capacitance sensor is used as a switch, on the basis of the acquired detection value.
(8) An input operation receiving apparatus of an aspect related to the invention includes a mechanical switch; a capacitance sensor provided so as to be superimposed on the mechanical switch; a contact determination unit that determines whether or not a contact operation to the capacitance sensor has been made, by comparing a detection value of the capacitance sensor with a threshold value; and a control unit that performs a processing of determining whether or not the mechanical switch is operating normally and when it is determined that the mechanical switch is not operating normally, the control unit performs generating of a control signal by considering a contact operation to the capacitance sensor as an operation to the mechanical switch.
(9) In the aspect of the above (8), the control unit may determine whether or not the mechanical switch is operating normally by comparing output of the mechanical switch with the threshold value.
(10) In the aspect of the above (8) or (9), the control unit may determine whether or not the mechanical switch is operating normally on the basis of output of the mechanical switch and a detection value of the capacitance sensor.
(11) In the aspect of the above (8) to (10), the control unit may adjust a detection sensitivity of the mechanical switch on the basis of an output of the mechanical switch and a detection value of the capacitance sensor.
(12) In the aspect of the above (8) to (11), the control unit may determine whether or not the capacitance sensor is operating normally on the basis of output of the mechanical switch.

According to the aspect of the above (1) to (3), the threshold value for contact determination when the capacitance sensor is used as a switch can be adjusted on the basis of the detection value (detection value at the time of operation) of the capacitance sensor when the operation of the mechanical switch has been detected. Therefore, the threshold value for contact determination when the capacitance sensor is used as a switch can be rapidly and appropriately adjusted.

According to the aspect of the above (4) and (5), the threshold value can be discontinuously changed with respect to the change of the detection value at the time of operation, at the boundary between the control region where the detection value at the time of operation is less than the predetermined value and the control region where the detection value at the time of operation is equal to or more than the predetermined value. Therefore, even if the operator wears gloves and the detection value of the capacitance sensor decreases greatly, contact with the capacitance sensor can be appropriately detected.

According to the aspect of the above (8) to (10), the capacitance sensor provided so as to be superimposed on the mechanical switch is included, and the control unit can perform the processing of determining whether or not the mechanical switch is operating normally, and when it is determined that the mechanical switch is not operating normally, the control unit can perform generating of a control signal by considering the contact operation to the capacitance sensor as an operation to the mechanical switch. Therefore, smooth alternative processing can be performed when abnormality occurs in the mechanical switch.

According to the aspect of the above (11), the detection sensitivity of the mechanical switch can be adjusted on the basis of the output of the mechanical switch and the detection value of the capacitance sensor. Therefore, when a degradation which does not lead the mechanical switch to a failure yet has occurred in the mechanical switch, it is possible to compensate the degradation of the sensitivity of the switch.

According to the aspect of the above (8) to (11), it is possible to determine whether or not the capacitance sensor is operating normally on the basis of the output of the mechanical switch. Therefore, the abnormality occurred in the capacitance sensor can be rapidly found and can be reported to the operator.

### BRIEF DESCRIPTION OF THE DRAWINGS

FIG. 1 is a view showing an example of the functional configuration of an input operation receiving apparatus of the present embodiment.
FIG. 2 is a view showing a state where the input operation receiving apparatus of the present embodiment is attached to a vehicle.
FIG. 3 is an explanatory view for describing an example of the functions of a composite switch.
FIG. 4 is an explanatory view for describing another example of the functions of the composite switch.
FIG. 5 shows an example of a flowchart showing the flow of processing executed by a control unit.
FIG. 6 is a view showing an example of the relationship between the duration time of a depression detection signal and a reference time.
FIG. 7 is a view showing an example of the relationship between the strength of a depression detection signal and a threshold value.
FIG. 8 is a view showing an example of the relationship between a detection value at the time of operation and a threshold value.
FIG. 9 is a view showing another example of the relationship between the detection value at the time of operation and the threshold value.

### DESCRIPTION OF THE REFERENCE SYMBOLS

- 1: INPUT OPERATION RECEIVING APPARATUS
- 10: COMPOSITE SWITCH
- 20: MECHANICAL SWICTH
- 30: CAPACITANCE SENSOR
- 40: SWITCH CONTROL DEVICE
- 42: MECHANIICAL SWITCH OPERATION DETERMINATION UNIT
- 44: CONTACT DETERMINATION UNIT
- 46: CONTROL UNIT
- 48: THRESHOLD VALUE ADJUSTMENT UNIT
- 50: STORAGE MEDIUM
- 55: TOUCH PANEL
- 60: STEERING WHEEL
- 70: CONTROL OBJECT EQUIPMENT

### DESCRIPTION OF EMBODIMENTS

### <First Embodiment>

Hereinafter, an embodiment of an input operation receiving apparatus and a threshold value adjusting method of the invention will be described with reference to the drawing.

### [Overall configuration]

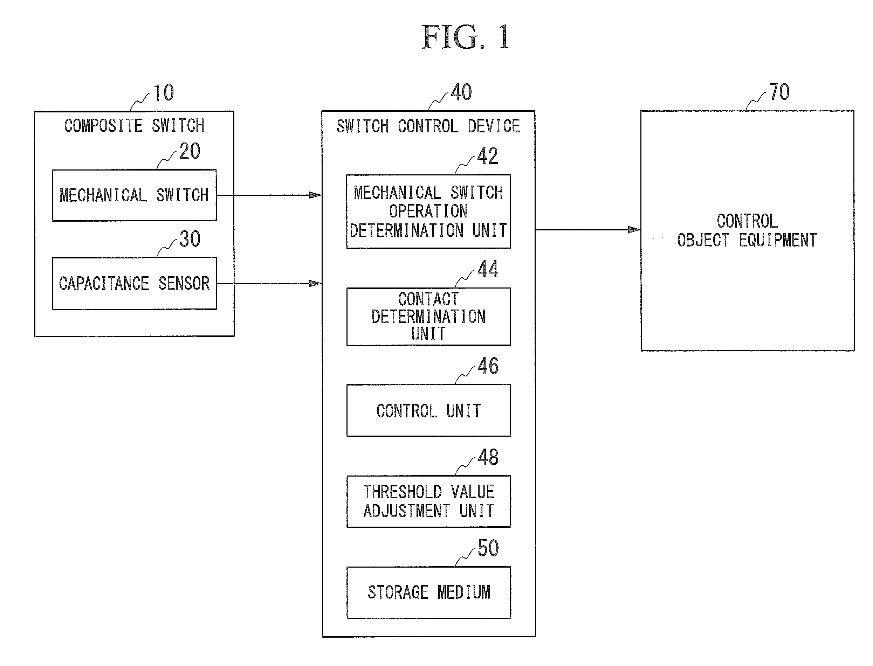

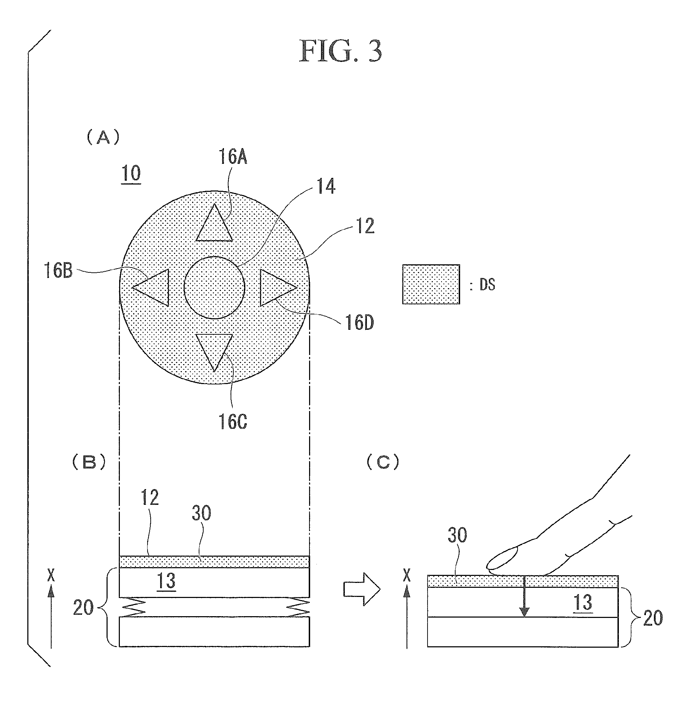

FIG. 1 is a view showing an example of the functional configuration of an input operation receiving apparatus 1 of the present embodiment. The input operation receiving apparatus 1 includes, for example, a composite switch 10, a switch control device 40, and a touch panel 55. The composite switch 10 has a structure in which a mechanical switch 20 and a capacitance sensor 30 are provided in a superimposed manner. That is, as shown in FIG. 3, the capacitance sensor 30 is arranged on the mechanical switch 20. The composite switch 10 is capable of detecting a depression operation or a tilt operation with respect to the mechanical switch 20, and an approach, a contact, or a slide to the capacitance sensor 30.

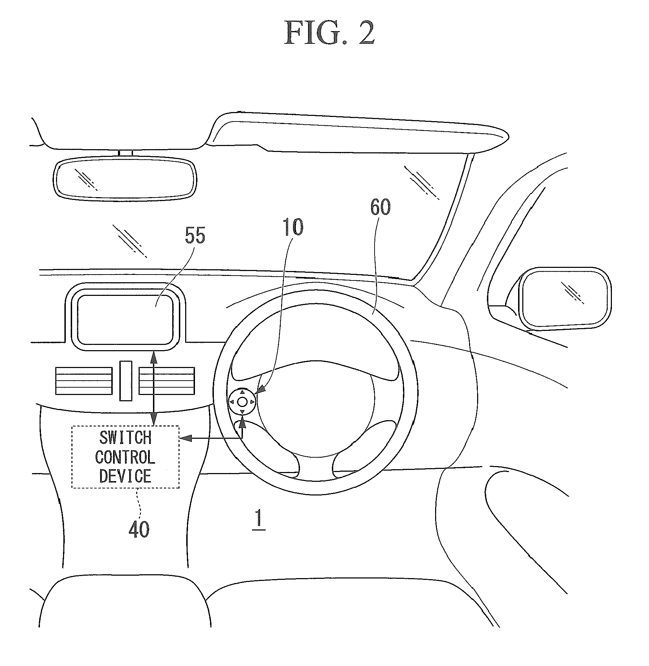

FIG. 2 is a view showing a state where the input operation receiving apparatus 1 of the present embodiment is attached to a vehicle. As shown in FIG. 2, the composite switch 10 is attached to, for example, a spoke portion of a steering wheel 60, or the like which are arbitrary positions where a driver (operator) can operate.

FIGS. 3A to 3C are explanatory views for describing an example of the functions of the composite switch 10. In the composite switch 10, for example, the whole surface of a surface 12 serves as a detection surface DS of the capacitance sensor 30. Additionally, guide displays 14 and 16A to 16D are drawn or formed on the surface 12 so that the operator can easily recognize the operation to the composite switch 10. The operator can perform the operation of depressing the vicinity (whole composite switch 10) of the guide display 14 and the operation (tilt operation) of depressing the vicinities of the guide displays 16A to 16D with respect to the composite switch 10. In addition, the composite switch 10 may only perform one of the operation of a depression operation and a tilt operation.

FIG. 3B is a side view when the composite switch 10 is viewed from a side surface. A member 13 includes the surface 12 of the composite switch 10 and is biased in the +X direction in the drawing, for example by a spring or the like. FIG. 3C is a view showing a state where the vicinity of the guide display 14 is depressed by an operator's finger or the like. In this state, the member 13 is displaced in the -X direction in the drawing, the displacement is detected by a depression detecting mechanism that is not shown, and a depression detection signal is output to the switch control device 40. This is also the same in a case where the vicinities of the guide displays 16A to 16D are depressed. At this time, the detection surface DS of the capacitance sensor 30 detects a change in capacitance caused by the operator's finger having come into contact therewith, and a detection value is output to the switch control device 40.

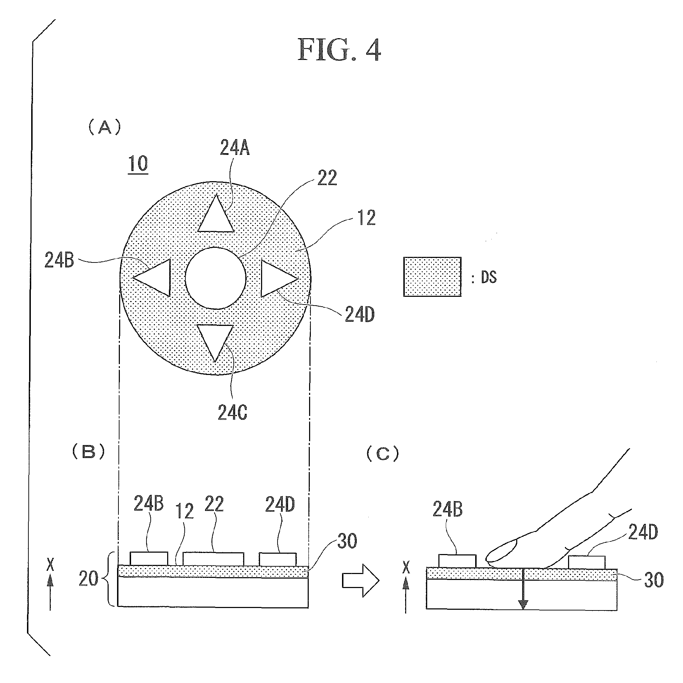

FIGS. 4A to 4C are explanatory views for describing another example of the functions of the composite switch 10. The composite switch 10 has, for example, a structure in which button portions 22 and 24A to 24D protrude from holes formed in the surface 12. Additionally, portions other than the holes in the surface 12 serve as the detection surface DS of the capacitance sensor 30. The operator can perform the operation of depressing the button portion 22 and the operation of depressing the button portions 24A to 24D, with respect to the composite switch 10.

FIG. 4B is a side view when the composite switch 10 is viewed from a side surface. Each button portion of the composite switch 10 are biased in the +X direction in the drawing, for example, by a spring or the like. FIG. 4C is a view showing a state where the button portion 22 is depressed by an operator's finger or the like. In this state, the button portion 22 is displaced in the -X direction in the drawing and is housed inside the composite switch 10, the displacement is detected by a depression detecting mechanism that is not shown, and a depression detection signal is output to the switch control device 40. This is also the same in a case where the button portions 24A to 24D are depressed. At this time, the detection surface DS of the capacitance sensor 30 detects a change in capacitance caused by the operator's finger having come into contact therewith, and a detection value is output to the switch control device 40.

Since the structure of the capacitance sensor 30 is well-known, the detailed description thereof is omitted. The capacitance sensor 30 may have a well-known configuration including a shielding electrode, a detecting electrode, an oscillator, or the like.

### [Outline of Switch Control Device]

Referring back to FIG. 1, the switch control device 40 will be described. The switch control device 40 has, for example, a configuration in which a central processing unit (CPU) are arranged in in the center and in which communication interfaces such as storage media 50, a timer (not shown), and a controller area network (CAN) driver (not shown), are connected to each other via buses. The storage media includes such as a random access memory (RAM), a read-only memory (ROM), a hard disk drive (HDD), a flash memory, and an electrically erasable programmable read-only memory (EEPROM). The switch control device 40 outputs various control signals to control object equipment 70, on the basis of an operation performed on the composite switch 10.

The control object equipment 70 mounted on the vehicle includes, for example, an air-conditioner, an audio device, a navigation device, and other devices. When the vicinity of the guide display 14 or the button portion 22 in the composite switch 10 is depressed, the control object equipment 70 is controlled, for example, as determined that a "determination" operation is input. Additionally, when the guide displays 16A to 16D or the button portions 24A to 24D are depressed (when a tilt operation is made), the control object equipment 70 is controlled as determined that a scrolling operation, an up-and-down operation for a function selection device, volume, or set room temperature, or the like is input. The switch control device 40 may detect the above operation or may detect the operation in consideration of the detection value input from the capacitance sensor 30, using only the depression detection signal input from the mechanical switch 20 of the composite switch 10. When an operation is detected in consideration of the detection value input from the capacitance sensor 30, the switch control device 40 determines that the composite switch 10 is contacted and operated when the detection value input from the capacitance sensor 30 is equal to or more than a first threshold value.

Additionally, the switch control device 40 can perform control according to the movement (so-called sliding operation and flick operation) of an operator's finger that comes in contact with the detection surface DS of the capacitance sensor 30. These operations are recognized by the switch control device 40 separately from operations against the mechanical switch 20. In this case, the control object equipment 70 may be controlled as determined that a scrolling operation, an up-and-down operation of a function selection device, volume, or set room temperature, or the like is input, or the control object equipment 70 may be controlled as determined that other operations are input.

In the present embodiment, the switch control device 40 is described as independent hardware. However, in practice, the switch control device 40 may be one function of a control computer of the above mentioned control object equipment 70.

The touch panel 55 shown in FIG. 2 is shared with, for example, the navigation device mounted in the vehicle. The touch panel 55 detects a change in capacitance caused by the operator's finger contact therewith, and a contact position, and output a detection value to the switch control device 40. The switch control device 40 determines that the touch panel 55 is contacted and operated when the detection value input from the touch panel 55 is equal to or more than a second threshold value. The first threshold value and the second threshold value may be the same or may be different. By the above mentioned configuration, the touch panel 55 can receive an operation, such as tapping, flicking, scrolling, swiping, or the like performed by the operator. Since the structure of the touch panel 55 is well-known, a detailed description thereof is omitted here. A surface type capacitance sensor may be included or a projection type capacitance sensor may be included.

### [Functional Configuration of Switch Control Device]

The switch control device 40 includes a mechanical switch operation determination unit 42, a contact determination unit 44, a control unit 46, and a threshold value adjustment unit 48, as functional blocks that function when the CPU executes a program stored in the storage medium.

The mechanical switch operation determination unit 42 determines that the mechanical switch 20 has been operated, for example, when a depression detection signal lasts for a reference time or lasts longer than the reference time. Additionally, the mechanical switch operation determination unit 42 may determine whether or not the mechanical switch 20 has been operated by comparing the depression detection signal to a threshold value when the depression detection signal is not a binary value of 0 or 1 but a signal which has intensity.

The contact determination unit 44 determines that a contact operation has been made on the capacitance sensor 30 when the detection value of the capacitance sensor 30 is equal to or more than the first threshold value. In addition, a plurality of values may be input to the contact determination unit 44 as the detection value of the capacitance sensor. In this case, however, the contact determination unit 44 handles the average value, maximum value, weighted average value of the plurality of detection values, and other calculation results obtained by suitable calculation as the detection value of the capacitance sensor.

The control unit 46, as will be described below, determines whether or not the mechanical switch 20 is operating normally and whether or not the capacitance sensor 30 is operating normally, and adjust the detection sensitivity of the mechanical switch 20, makes the capacitance sensor 30 and the contact determination unit 44 substitute for the function of the mechanical switch 20, or detects the abnormality of the capacitance sensor 30.

### [Processing by Control unit 46]

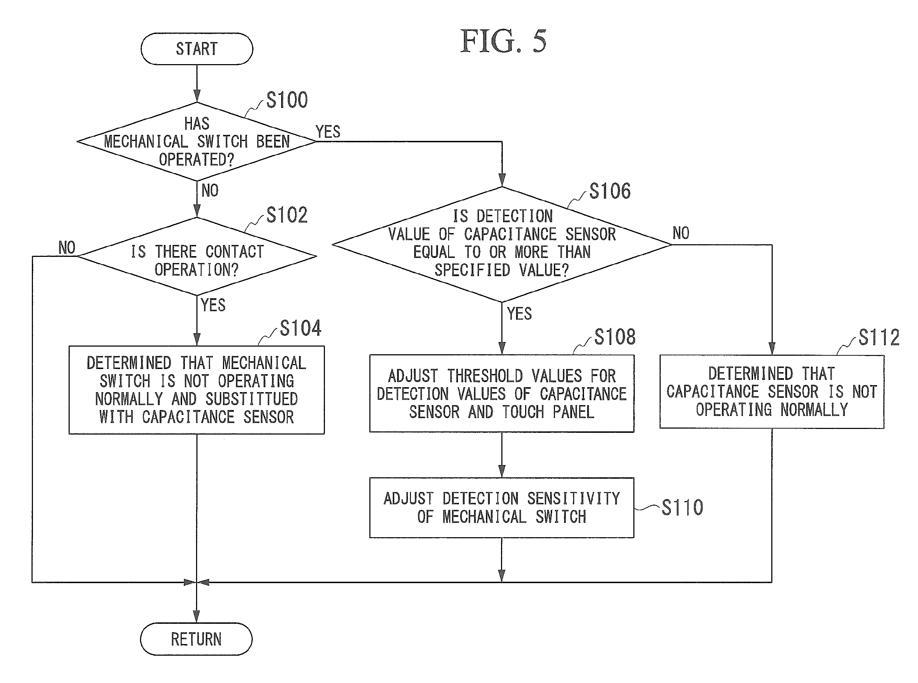

Hereinafter, the processing executed by the control unit 46 will be described. FIG. 5 shows an example of a flowchart showing the flow of the processing executed by the control unit 46. The flowchart of FIG. 5, for example, is repeatedly executed in a predetermined cycle.

First, the control unit 46 determines whether or not the mechanical switch 20 has been operated with reference to the determination result of the mechanical switch operation determination unit 42 (Step S100). When the mechanical switch 20 is not operated, the control unit 46 determines whether a contact operation has been made on the capacitance sensor 30 with reference to the determination result of the contact determination unit 44 (Step S102).

When the mechanical switch 20 is not operated and a contact operation has been made on the capacitance sensor 30, the control unit 46 determines that the mechanical switch 20 is not operating normally, and makes the capacitance sensor 30 and the contact determination unit 44 substitute for the operation of the mechanical switch 20 (Step S104). That is, the control unit 46 regards the contact operation against the capacitance sensor 30 as an operation against the mechanical switch 20, and generates a control signal to the control object equipment 70. In addition, when the mechanical switch 20 is not operated and a contact operation is not made against the capacitance sensor 30, the control unit 46 ends one routine of the flowchart in FIG. 5.

On the other hand, when it is determined in Step S100 that the mechanical switch 20 has been operated, the control unit 46 determines whether the detection value of the capacitance sensor 30 is equal to or more than a specified value (Step S106). Here, the "specified value" may be the same as or may be different from the first threshold value related to the contact determination of the capacitance sensor 30.

When the detection value of the capacitance sensor 30 is equal to or more than a specified value, the control unit 46 makes the threshold value adjustment unit 48 to adjust the first threshold value for the detection value of the capacitance sensor 30 and the second threshold value for the detection value of the touch panel 55 (Step S108). The threshold value adjustment unit 48 adjusts the first threshold value, for example, so that the first threshold value become larger as the detection value of the capacitance sensor 30 increases. The details of processing of the threshold value adjustment unit 48 will be described below. The adjusted first threshold value and the second threshold value are stored in the storage medium 50.

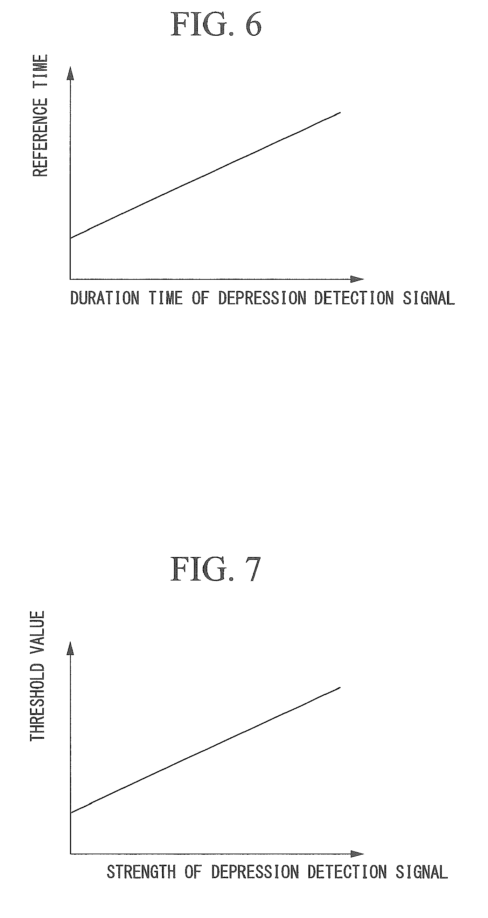

Next, the control unit 46 makes the mechanical switch operation determination unit 42 to adjust the detection sensitivity of the mechanical switch 20 (Step S110). The mechanical switch operation determination unit 42, for example, changes the "reference time" according to a time for which the current depression detection signal has lasted. The reference time is a time in which it is determined that the mechanical switch 20 has been operated in a case where a depression detection signal has last for the reference time or has last longer than the reference time. FIG. 6 is a view showing an example of the relationship between the duration time of the depression detection signal and the reference time. In FIG. 6, although it is supposed that the relationship changes linearly, the relationship may be changed in a curved manner or in a staircase manner. This is also the same in FIGS. 7 to 9 to be described below.

Additionally, in a case where the depression detection signal is not a binary value of 0 or 1 but a signal which has intensity, the mechanical switch operation determination unit 42 changes the threshold value according the strength of a depression detection signal when it is determined that the mechanical switch 20 has been operated by comparing the depression detection signal with the threshold value. FIG. 7 is a view showing an example of the relationship between the strength of the depression detection signal and the threshold value. The reference time and the threshold value after adjustment are stored in the storage medium 50.

In addition, the threshold value or the reference time stored in the storage medium 50 may be reset or may be used continuously when a vehicle system is brought into an OFF state (for example, when ACC (accessory power source) is OFF).

In Step S106, when it is determines that the detection value of the capacitance sensor 30 is less than the specified value, the control unit 46 determines that the capacitance sensor 30 is not operating normally (Step S112). In this case, the control unit 46 performs processing to have a display device (not shown) display information which indicates that abnormality has occurred in the capacitance sensor 30.

### [Adjustment of Threshold value]

Hereinafter, adjustment of the threshold value (the first threshold value and the second threshold value) for contact determination executed by the threshold value adjustment unit 48 will be described. As mentioned above, when the capacitance sensor 30 is used as a switch, the detected capacitance fluctuates according to whether or not gloves are worn by the operator, differences between individuals, the state (sweat or injury) of fingertips (hereinafter referred to as operator's conditions), or the like. Therefore, it is desirable to appropriately adjust the threshold value.

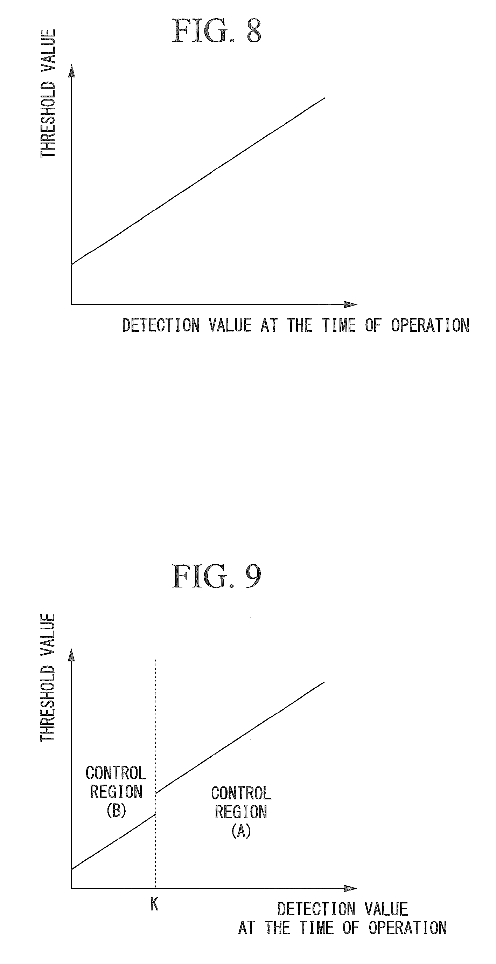

The switch control device 40, as mentioned above, adjusts the threshold value for contact determination in the capacitance sensor 30 and/or the touch panel 55 on the basis of the detection value (hereinafter referred to as a detection value at the time of operation) of the capacitance sensor 30 when the operation of the mechanical switch 20 has been detected. More specifically, the switch control device 40 adjusts the threshold value with a tendency in which the threshold value increases as the detection value at the time of operation increases. As a result, the threshold value is adjusted to values on which the operator's conditions are reflected appropriately. FIG. 8 is a view showing an example of the relationship between the detection value at the time of operation and the threshold value.

The switch control device 40 set a map or a function shown in FIG. 8 in advance, and adjusts the threshold value, for example, immediately after the detection value at the time of operation is input. Since the detection value at the time of operation is a detection value when the operation of the mechanical switch 20 has been detected, the probability that the operator has contacted and operated the capacitance sensor 30 is high. For this reason, even if adjustment of the threshold value is performed by single sampling, the reliability as the switch does not degrade. Therefore, the input operation receiving apparatus 1 of the present embodiment can rapidly and appropriately adjust the threshold value for contact determination when the capacitance sensor 30 is used as a switch.

Additionally, the switch control device 40 may have a different relationship between the detection value at the time of operation and the threshold value compared to that of shown in FIG. 8 in consideration of that the detection value of the capacitance sensor 30 decreases greatly when the operator wears gloves. FIG. 9 is a view showing another example of the relationship between the detection value at the time of operation and the threshold value. As shown in FIG. 9, as for the switch control device 40, in a control region (A) where the detection value at the time of operation is less than a predetermined value K and a control region (B) where the detection value at the time of operation is equal to or more than the predetermined value K, the threshold value may be continuously changed with respect to changes in the detection value at the time of operation, and the change of the threshold value may be discontinuous at a boundary line between the control region (A) and the control region (B). In this case, the value threshold valuein the vicinity of the boundary line of the threshold value of control region (B) is enlarged discontinuously compared to the value threshold valuein the vicinity of the boundary line of the threshold value of the control region (A). Accordingly, even if the operator wears gloves and the detection value of the capacitance sensor 30 or the touch panel 55 decreases greatly, contact with the capacitance sensor 30 or the touch panel 55 can be appropriately detected.

### [Conclusion]

According to the input operation receiving apparatus 1 of the present embodiment described above, it is able to determine whether or not the mechanical switch 20 is operating normally on the basis of the output of the capacitance sensor 30, and perform a processing of generating a control signal by regarding a contact operation to the capacitance sensor 30 as an operation to the mechanical switch 20 when it is determined that the mechanical switch is not operating normally. Therefore, smooth alternative processing can be performed when an abnormality occurs.

Additionally, according to the input operation receiving apparatus 1 of the present embodiment, the detection sensitivity of the mechanical switch 20 can be adjusted on the basis of the output of the mechanical switch 20 and the detection value of the capacitance sensor 30. Therefore, when a degradation which does not lead the mechanical switch to a failure yet has occurred in the mechanical switch 20, it is possible to compensate the degradation of the sensitivity of the switch.

Additionally, according to the input operation receiving apparatus 1 of the present embodiment, it is possible to determine whether or not the capacitance sensor 30 is operating normally on the basis of the output of the mechanical switch 20. Therefore, the abnormality occurred in the capacitance sensor 30 can be rapidly found and can be reported to the operator.

Additionally, according to the input operation receiving apparatus 1 of the present embodiment, the threshold value for contact determination when the capacitance sensor is used as a switch can be adjusted on the basis of the detection value (detection value at the time of operation) of the capacitance sensor 30 when the operation of the mechanical switch 20 has been detected. Therefore, the threshold value can be rapidly and appropriately adjusted.

Additionally, according to the input operation receiving apparatus 1 of the present embodiment, the mechanical switch 20 and the capacitance sensor 30 are provided in a superimposed manner. Therefore, the probability that the detection value at the time of operation is equal to a detection value when a contact operation has been made to the capacitance sensor 30 becomes high. As a result, in the input operation receiving apparatus 1, it is unnecessary to perform sampling of the detection value repeatedly and the threshold value can be rapidly and appropriately adjusted.

Additionally, according to the input operation receiving apparatus 1 of the present embodiment, it is possible to make the change of the threshold value discontinuously at the boundary line between the control region (A) where the detection value at the time of operation is less than the predetermined value K and the control region (B) where the detection value at the time of operation is equal to or more than the predetermined value K. Therefore, even if the operator wears gloves and the detection value of the capacitance sensor 30 or the touch panel 55 decreases greatly, contact with the capacitance sensor 30 or the touch panel 55 can be appropriately detected.

Although the form for carrying out the invention has been described above using the embodiment, the invention is not limited to such embodiment at all, and various modifications and substitutions can be added without departing from the scope of the invention.

For example, in the above embodiment, a threshold value is set with respect to the magnitude of a change in capacitance, and it is determined that the capacitance sensor is contacted and operated when threshold value the change in capacitance is equal to or more than the threshold value. However, when the capacitance sensor outputs a signal, (for example, a voltage signal or the like) which becomes to a smaller value as the change in capacitance becomes larger, as a detection value, threshold valueit may be determined that the capacitance sensor has been contacted and operated when the detection value is equal to or less than the threshold value. In this case, the relationship illustrated to FIGS. 8 and 9 becomes a relationship in which up and down are reversed.

Additionally, regarding the capacitance sensor 30 or the touch panel 55, the switch control device 40 may perform only the processing of adjusting a threshold value, the adjusted threshold value may be transmitted to a control subject that perform control by using an operation against the capacitance sensor 30 or the touch panel 55, and this control subject may be adapted to perform contact determination. That is, the switch control device 40 may perform only the adjustment of the threshold value without performing the contact determination.

Additionally, the input operation receiving apparatus of the present embodiment can be applied not only to that mounted on a vehicle but also to all electric devices, such as a cellular phone and a tablet terminal, which perform contact detection.

Additionally, although the configuration in which the capacitance sensor 30 is superimposed on the switch that can detect a depression operation or a sliding operation has been illustrated in the above embodiment, the capacitance sensor 30 may be superimposed on other switches, such as a toggle switch and a dial switch. While preferred embodiments of the invention have been described and illustrated above,

it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

An input operation receiving apparatus (1) includes a mechanical switch (20); a capacitance sensor (30) that is provided at a position where an operator comes into contact therewith when the mechanical switch is operated and that detects capacitance; and an adjustment unit (48) that adjusts a threshold value for a contact determination when the capacitance sensor is used as a switch, on the basis of a detection value at a time of operation, the detection value at the time of operation being a detection value of the capacitance sensor when an operation of the mechanical switch is detected.

## Claims

1. An input operation receiving apparatus comprising:
a mechanical switch;
a capacitance sensor that is provided at a position where an operator comes into contact therewith when the mechanical switch is operated and that detects capacitance; and
an adjustment unit that adjusts a threshold value for a contact determination when the capacitance sensor is used as a switch, on the basis of a detection value at a time of operation, the detection value at the time of operation being a detection value of the capacitance sensor when an operation of the mechanical switch is detected.

2. The input operation receiving apparatus according to Claim 1,
wherein the capacitance sensor is provided so as to be superimposed on the mechanical switch.

3. The input operation receiving apparatus according to Claim 1 or 2,
wherein the adjustment unit adjusts the threshold value with a tendency in which the threshold value increases as the detection value at the time of operation increases.

4. The input operation receiving apparatus according to Claim 3,
wherein the adjustment unit continuously changes the threshold value with respect to a change of the detection value at the time of operation in both of a control region where the detection value at the time of operation is less than a predetermined value and a control region where the detection value at the time of operation is equal to or more than a predetermined value, and discontinuously changes the threshold value with respect to a change of the detection value at the time of operation at a boundary between a control region where the detection value at the time of operation is less than a predetermined value and a control region where the detection value at the time of operation is equal to or more than a predetermined value.

5. The input operation receiving apparatus according to Claim 4,
wherein the adjustment unit discontinuously increases the threshold value when the detection value at the time of operation is equal to or more than a predetermined value as compared to the threshold value when the detection value at the time of operation is less than a predetermined value, at a boundary between a control region where the detection value at the time of operation is less than a predetermined value and a control region where the detection value at the time of operation is equal to or more than a predetermined value.

6. The input operation receiving apparatus according to Claim 1 any one of Claims 1 to 5, further comprising:
another capacitance sensor that is different from the capacitance sensor that is formed so as to be superimposed on the mechanical switch and detects capacitance between the capacitance sensor and an approaching object,
wherein the adjustment unit adjusts a threshold value for contact determination when the capacitance sensor that is formed so as to be superimposed on the mechanical switch and detects the capacitance between the capacitance sensor and the approaching object is used as a switch, and/or a threshold value for contact determination when the another capacitance sensor is used as a switch.

7. A threshold value adjusting method that adjusts a threshold value for contact determination when a capacitance sensor is used as a switch, in an input operation receiving apparatus comprising a mechanical switch and the capacitance sensor that is formed so as to be superimposed on the mechanical switch and detects a capacitance between the capacitance sensor and an approaching object,
the method comprising:
acquiring a detection value of the capacitance sensor when an operation of the mechanical switch is detected; and
adjusting a threshold value for contact determination when the capacitance sensor is used as a switch, on the basis of the acquired detection value.
